## Europäisches Patentamt
## European Patent Office
## Office européen des brevets

(19)

(11) Veröffentlichungsnummer: **0 151 271**
**B1**

(12)

# EUROPÄISCHE PATENTSCHRIFT

(45) Veröffentlichungstag der Patentschrift:
**22.04.87**

(51) Int. Cl.⁴: **H 02 M 7/757**, H 01 L 25/14

(21) Anmeldenummer: **84115083.2**

(22) Anmeldetag: **10.12.84**

(54) **Gleichstrom-Kurzkupplung.**

(30) Priorität: **06.02.84 DE 3404076**

(43) Veröffentlichungstag der Anmeldung:
**14.08.85 Patentblatt 85/33**

(45) Bekanntmachung des Hinweises auf die Patenterteilung:
**22.04.87 Patentblatt 87/17**

(84) Benannte Vertragsstaaten:
**AT CH DE FR GB LI SE**

(56) Entgegenhaltungen:
**DE - A - 2 537 780**

**BROWN BOVERI REVIEW, Band 65, Nr. 9, September 1978, Seiten 578-584, Baden, CH; J. KÄUFERLE et al.: "The compact reliable convertor stations of Nelson River Bipole 2"**

(73) Patentinhaber: **Siemens Aktiengesellschaft Berlin und München, Wittelsbacherplatz 2, D-8000 München 2 (DE)**

(72) Erfinder: **Meisel, Michael, Am Tiefenweg 13, D-8524 Dormitz (DE)**
Erfinder: **Wiendl, Heinz, Dipl.-Ing., Georg-Ledebour-Strasse 36, D-8500 Nürnberg (DE)**

**Beschreibung**

Die Erfindung betrifft die räumliche Anordnung von Stromrichter-Funktionsgruppen einer Gleichstrom-Kurzkupplung zum Zusammenschalten zweier asynchroner Hochspannungs-Drehstromnetze gemäss dem Oberbegriff des Patentanspruchs 1.

Um den Stromaustausch zwischen zwei Netzen mit unterschiedlichem Frequenzverhalten (asynchrone Netze) zu ermöglichen, bedient man sich häufig eines zwischen den beiden Netzen angeordneten entkoppelten Gleichstromkreises in Form einer Drehstrom-Gleichstrom-Drehstrom-Umformung. Da die Hochspannungs-Gleichstromübertragung praktisch mit der Entfernung Null erfolgt, bezeichnet man diesen Gleichstromkreis als «Gleichstrom-Kurzkupplung».

Eine solche Gleichstrom-Kurzkupplung für die Verbindung zweier asynchroner Hochspannungsnetze ist bekannt und in «Österreichische Zeitschrift für Elektrizitätswirtschaft», Jahrgang 36, Heft 8/9, Seite 265 ff beschrieben. Sie besteht im wesentlichen aus zwei gleichstromseitig miteinander verbundenen, drehstromseitig an die beiden Netze angeschlossenen Drehstrom-Vollweg-Stromrichteranordnungen, die anstelle von passiven Gleichrichterventilen steuerbare Gleichrichterbauelemente (Thyristoren) enthalten. Dies ist deshalb notwendig, weil der Stromaustausch zwischen den beiden gekoppelten Netzen wahlweise in beiden Richtungen erfolgen soll. Dabei muss die dem speisenden Netz zugeordnete Stromrichteranordnung als Gleichrichter und die dem eingespeisten Netz zugeordnete Stromrichteranordnung als Wechselrichter arbeiten. Bei einer Stromrichtungsumkehr muss auch die Arbeitsweise der Stromrichteranordnungen gewechselt werden. Da die Betriebsart also nur von der Polarität der Stromrichterspannungen abhängt, ist die Übertragungseinrichtung und die Höhe des Energieflusses nur durch die Steuerung der Anlage bestimmt und praktisch unabhängig von den Spannungs- und Frequenzverhältnissen in den angeschlossenen Drehstromnetzen. Voraussetzung dafür ist das Vorhandensein einer zentralen Thyristorelektronik, bei der jedem Thyristor eine Thyristorelektronik-Baugruppe zugeordnet ist, die aus einem Leistungsteil für die Bildung und Abgabe eines elektronischen Zündimpulses, einer informationsverarbeitenden Elektronik sowie einer Signalübertragungseinheit besteht. Die Signalübertragung selbst erfolgt aus verschiedenen Gründen, die für die vorliegende Erfindung jedoch keine Rolle spielen, über Lichtleiterkabel.

In bekannten Anordnungen von Hochspannungs-Gleichstrom-Kurzkupplungen arbeiten je zwei Stromrichtertransformatoren, von deren Sekundärwicklungen eine in Stern und die andere in Dreieck geschaltet sind, auf einen Drehstrom-Vollweg-Gleichrichter mit 12 Halbleiter-Gleichrichter-Bauelementen. Jeder der drei sekundären Drehstromphasen der beiden Stromrichtertransformatoren sind also je zwei hintereinandergeschaltete Halbleiterbauelemente zugeordnet, so dass je vier Halbleiterbauelemente eine Halbleiterbaugruppe bilden. Dabei besteht jedes Halbleiterbauelement aus zwei hintereinandergeschalteten Thyristoren. Diese acht Thyristoren werden üblicherweise übereinander angeordnet und bilden zusammen einen sogenannten Ventilturm. Die bekannten Anlagen bestehen demzufolge aus insgesamt sechs in einer sogenannten Ventilhalle untergebrachten Ventiltürmen. Jeder dieser Ventiltürme ist wechselstromseitig mit je einem sekundären Phasenanschluss der beiden zugeordneten Stromrichtertransformatoren und über je eine Gleichstromschiene mit den beiden anderen, dem betreffenden Netz zugeordneten Ventiltürmen verbunden.

Nachdem die vier Stromrichtertransformatoren gewöhnlich aussen, zu je zwei an beiden Längsseiten der Ventilhalle angeordnet sind und jeder der beiden Transformatoren über je eine Zuleitung mit jedem der drei Ventiltürme verbunden werden muss, entsteht eine Vielzahl sich kreuzender Hochspannungs-Verbindungsleitungen mit einem entsprechend grossen Raumbedarf. Es kommt hinzu, dass die je drei nebeneinander angeordneten Ventiltürme eines Netzes über die schon erwähnten Lichtleiterkabel mit der jeweiligen Thyristorelektronik verbunden werden müssen. Dazu bedient man sich spezieller, hochspannungsfester Lichtleiterkabel, deren Übertragungsreichweite jedoch begrenzt ist. So ist es beispielsweise bei der bekannten Anordnung nicht möglich, die Transistor-Elektronik an einer der Stirnseiten der Ventilhalle auf gleicher Ebene der Ventiltürme und Transfomatoren anzuordnen, weil dann die maximale Übertragungslänge der Lichtleiterkabel überschritten würde. Man war deshalb gezwungen, die Ventilhalle zu unterkellern und die Thyristorelektronik zum Zwecke kurzer Übertragungswege dort anzuordnen.

Die Erfindung liegt die Aufgabe zugrunde, durch eine kompaktere Gestaltung insbesondere der Halbleiteranordnung, die vorgenannten Nachteile zu beseitigen.

Diese Aufgabe wird durch die im Patentanspruch 1 angegebene Erfindung gelöst. Damit ist vor allem erreicht, dass der Flächenbedarf der Halbleitertürme um etwa 1/3 reduziert ist und dass gleichzeitig nicht mehr jeder Turm einer Halbleitereinheit mit je einer Phase der beiden Stromrichtertransformatoren verbunden werden muss, sondern alle drei Phasen jeder Sekundärwicklung einem einzigen Turm zugeführt werden können. Dadurch erübrigt sich die Querführung und Überkreuzung von Anschlussleitungen. Darüberhinaus ist erreicht, dass sich die Kantenlänge der von den Stromrichtertürmen beanspruchten Fläche auf ein solches Mass verringert hat, dass die Thyristorelektronik an einer der Stirnseiten der Halbleiterhalle auf gleicher Ebene wie die Halbleitertürme angeordnet werden kann. Dadurch ist es möglich, die Unterkellerung der Stromrichterhalle zu vermeiden und damit die Baukosten erheblich zu senken. Der Umstand, dass die Bauhöhe der Stromrichtertürme nach der vorliegenden Erfindung wegen der beiden zusätzlichen Thyristorebenen etwas grösser ist als bei denjenigen nach dem Stand der Technik ändert an dieser Kosteneinsparung relativ wenig, weil der grössere Flächenbedarf und die Unterkellerung wesentlich stärker zu Buche schlagen als die notwendige Vergrösserung der Hallenhöhe.

Ein Ausführungsbeispiel der Erfindung wird anhand der Zeichnungen im folgenden näher erläutert. Es zeigen:

Fig. 1 ein Übersichtschaltbild einer Hochspannungs-Gleichstrom-Kurzkupplung für die Verknüpfung zweier asynchroner Hochspannungsnetze;

Fig. 2 eine schematische Darstellung der in zwei Türmen zusammengefassten Thyristoren eines Netzes;

Fig. 3 eine Grundrissdarstellung der Stromrichterhalle mit Stromrichtertransformatoren, Glättungsdrosseln und Thyristorsteuerelektronik;

Fig. 4 einen Längsschnitt durch die Stromrichterhalle mit Glättungsdrossel und Thyristorsteuerelektronik und

Fig. 5 einen Querschnitt durch die Stromrichterhalle mit den Stromrichtertransformatoren.

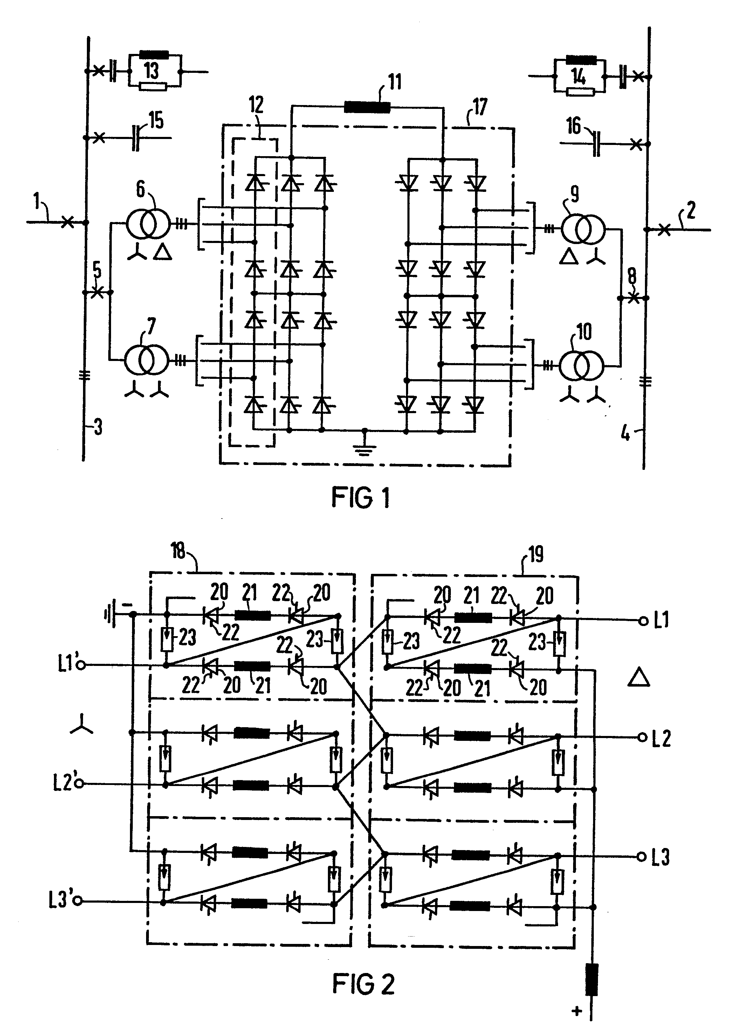

Gemäss dem Übersichtsschaltbild nach Fig. 1 gelangen die Drehstromfreileitungen der miteinander zu verknüpfenden asynchronen Drehstromnetze 1 und 2 zunächst an die Drehstromsammelschienen 3, 4 der Kupplungsanlage. Die Sammelschiene 3 ist über Anschlussleitungen 5 mit den Primäranschlüssen der Stromrichtertransformatoren 6 und 7, die Sammelschiene 4 über die Anschlussleitungen 8 mit den Primäranschlüssen der Stromrichtertransformatoren 9 und 10 verbunden. Von den beiden dem Netz 1 zugeordneten Stromrichtertransformatoren ist die Sekundärwicklung des Transformators 6 in Dreieck und diejenige des Transformators 7 in Stern geschaltet. Entsprechendes gilt für die dem Netz 2 zugeordneten Stromrichtertransformatoren 9 und 10. Jeder sekundäre Phasenanschluss ist in bekannter Weise mit dem Drehstromanschluss eines Drehstrom-Vollweg-Gleichrichters verbunden, von denen jeder mit 12 Thyristoren ausgerüstet ist. Die Schaltung ist bekannt und bedarf keiner näheren Erläuterung. Die beiden Gleichrichtersysteme sind gleichspannungsseitig mit ihren geerdeten Minuspolen unmittelbar und mit den Pluspolen über eine Glättungsdrossel 11 miteinander verbunden.

Bei der bekannten Kupplungsanordnung sind nun jeweils vier der in Serie geschalteten Thyristoren jedes der drei Stromrichterzweige jedes Vollweg-Gleichrichters zu je einem gestrichelt dargestellten sogenannten Stromrichterturm 12 in vier Ebenen übereinanderliegend zusammengefasst.

Weiterhin sind den Sammelschienen 3, 4 je ein Hochpassfilterkreis 13 und 14 sowie Glättungskondensatoren 15, 16 zugeordnet. Die insgesamt sechs Stromrichtertürme 12 sind in einer strichpunktiert angedeuteten Stromrichterhalle 17 untergebracht.

Wegen des symmetrischen Aufbaues der Kupplungsanlage und der Verwendung von Thyristoren in beiden Vollweg-Gleichrichtern besteht die Möglichkeit, die Stromflussrichtung durch entsprechende Steuerung der Thyristoren so zu wählen, dass entweder vom Netz 1 in das Netz 2 eingespeist wird oder umgekehrt. Die Energieflussrichtung ist also mit Hilfe einer Transistor-Steuerelektronik frei wählbar. Die Stromrichtertransformatoren 6, 7 bzw. 9, 10 haben zum einen die Aufgabe, die Spannung der beiden Drehstromnetze auf einen für die Stromrichter passenden Wert zu transformieren und zum anderen die Drehstromnetze vom Gleichstromkreis zu isolieren.

Die Glättungsdrossel 11 dient einerseits zum Herabsetzen der Gleichstromwelligkeit, andererseits aber auch zum Begrenzen des Kurzschlussstromes bei Thyristorkurzschlüssen. Durch die Phasenanschnittsteuerung der Thyristoren entstehen Oberwellen, die in den Drehstromnetzen zu Spannungsverzerrungen und ausserdem zur Beeinflussung von sich kreuzenden oder parallel geführten Fernmeldeleitungen führen können. Darüberhinaus bewirken diese Oberwellen eine zusätzliche thermische Belastung von Transformatoren, Kondensatoren und Übertragungsleitungen, die für einen sinusförmigen Verlauf ausgelegt sind. Es ist daher notwendig, die drehstromseitigen Oberwellen durch Hochpassfilter 13, 14 abzusaugen. Nachdem gleichspannungsseitig nur Wirkleistung übertragen werden kann, muss der Blindleistungsbedarf drehstromseitig durch die Kondensatorbatterien 15, 16 aufgebracht werden.

Aus der Fig. 1 ist zu erkennen, dass die Zusammenfassung der vier hintereinandergeschalteten Thyristoren zu je einem Turm 12 voraussetzt, dass jeder dieser Türme mit je einer Drehstromphase der Sekundärwicklungen jedes der beiden einem Netz zugeordneten Stromrichter-Transformatoren verbunden ist. Dies führt zu einer relativ aufwendigen, über Kreuz geführten, langen und daher raumgreifenden wechselstromseitigen Anschlussverkabelung. Ausserdem benötigen die sechs Stromrichtertürme eine verhältnismässig grosse Grundfläche, was zu den geschilderten Problemen bei der Steuerverkabelung zu den Thyristoren führt.

Bei der Erfindung ist daher die Zusammenfassung dre Stromrichteranordnung zu Stromrichtertürmen anders gelöst und zwar so, dass nicht die vier in Serie geschalteten Stromrichter einer Vollweg-Gleichrichteranordnung jeweils zu einen Turm zusammengefasst sind, sondern die je einer Sekundärwicklung der Stromrichtertransformatoren zugeordneten parallelgeschalteten, aus je zwei in Serie geschalteten Thyristoren gebildeten Gruppen. Diese Anordnung ist in Fig. 2 schematisch dargestellt. Dabei enthält der linke Turm 18 die der sekundären Sternwicklung L1', L2', L3' des Stromrichtertransformators 10 und der rechte Turm 19 die der sekundären Dreieckwicklung L1, L2, L3 des Stromrichtertransformators 9 zugeordneten Stromrichter-Baugruppe. Dabei entsprechen jedem der in Fig. 1 dargestellten Stromrichter in der Darstellung nach Fig. 2 zwei in Serie geschaltete gleichartige Thyristoren 20 mit dazwischenliegenden Ventildrosseln 21. Die Steueranschlüsse 22 der Thyristoren sind an nicht dargestellte Steuerleitungen angeschlossen, die sie mit einer Thyristor-Steuerungselektronik verbinden. Ferner ist je zwei hintereinandergeschalteten Thyristoren je ein Ventilableiter 23 zur Überspannungsableitung parallel geschaltet.

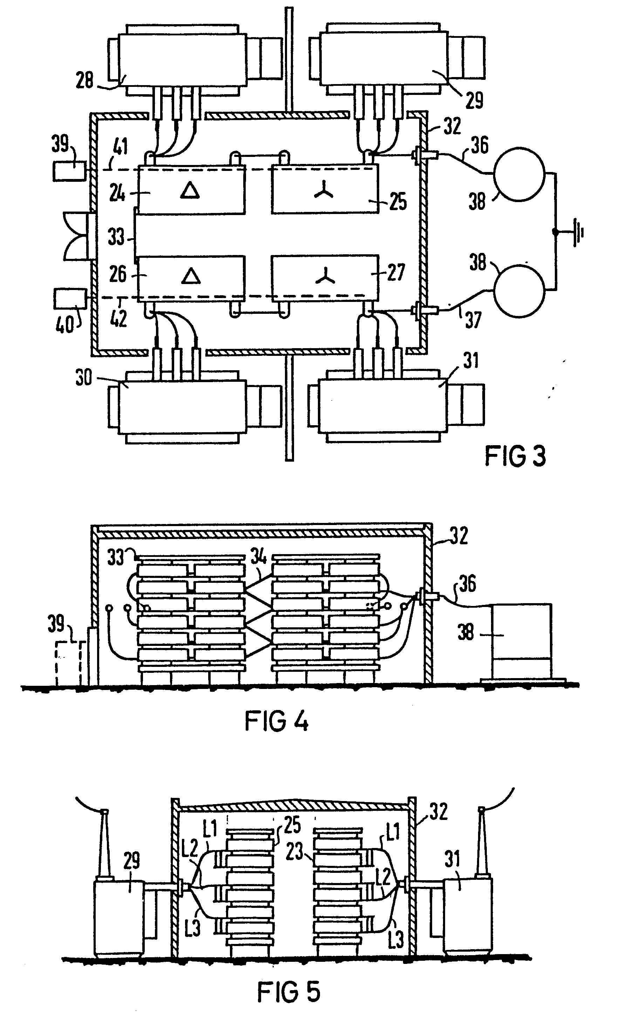

In Fig. 3 ist die gesamte Kupplungsanordnung im Grundriss schematisch dargestellt. Erkennbar sind die vier Stromrichtertürme 24 bis 27 im Rechteck so angeordnet, dass ihre Drehstromanschlüsse den jeweils zugeordneten Stromrichtertransformatoren 28, 29, 30, 31 gegenüberliegen.

Diese Transformatoren befinden sich ausserhalb der Stromrichterhalle 32, welche die Stromrichtertürme umschliesst. Dadurch ergeben sich drehstromseitig relativ kurze, nicht kreuzende Verbindungsleitungen. Ersichtlich sind auch die Gleichstromschienen 33, 34, 35 zur Verbindung der Stromrichtertürme untereinander wie die Zuleitungen 36, 37 zu den Glättungsdrosseln 38 so günstig anzuordnen, dass sie die minimal mögliche Länge und damit den günstigsten Wirkungsgrad erreichen.

Nachdem die Kantenlänge der Längsseiten der Stromrichtertürme nur 2/3 derjenigen der bisherigen Anordnung mit sechs Türmen erreicht, kann die nur schematisch angedeutete Thyristor-Steuerungselektronik 39, 40 problemlos auf der gleichen Ebene untergebracht werden, wie die Türme und die Transformatoren. Die Länge der Lichtleiter-Verbindungskabel 41, 42 ist bei dieser Anordnung deutlich kürzer als die maximal mögliche Übertragungslänge solcher für eine Hochspannungsumgebung geeigneter Kabel.

In Fig. 4 ist der prinzipielle Aufbau der Stromrichtersäulen in einem Längsschnitt durch die Stromrichterhalle dargestellt. Darin ist nochmals zu erkennen, dass es gelungen ist, sowohl die drehstromseitigen wie die gleichstromseitigen Zu- und Verbindungsleitungen kurz und übersichtlich zu gestalten. Diese ergibt sich in aller Deutlichkeit auch das der Querschnittsdarstellung in Fig. 5.

## Patentansprüche

1. Räumliche Anordnung von Stromrichter-Funktionsgruppen einer Gleichstrom-Kurzkupplung zum Zusammenschalten zweier asynchroner Hochspannungs-Drehstromnetze (1, 2), bestehend aus einer jedem der zu kuppelnden Netze zugeordneten Drehstrom-Vollweg-Stromrichteranordnung mit Stromrichtertransformatoren (6, 7, 9, 10) und steuerbaren Halbleitern, die von einer zentralen Steuerungselektronik so gesteuert werden, dass die eingangsseitige Stromrichteranordnung als Gleichrichter und die ausgangsseitige Stromrichteranordnung als Wechselrichter arbeitet und die steuerbaren Halbleiter einzelner Funktionsgruppen derart übereinander angeordnet sind, dass gleichartig aufgebaute Stromrichtertürme gebildet werden, die gleichstromseitig gleichpolig untereinander und drehstromseitig mit den zugeordneten in Stern und Dreieck geschalteten Sekundärwicklungen der Stromrichtertransformatoren verbunden sind, dadurch gekennzeichnet, dass jede der den vier Sekundärwicklungen der Stromrichtertransformatoren (28, 29, 30, 31) zugeordneten Vollweg-Halbleiterbaugruppen einen Stromrichterturm (24, 25, 26, 27) bildet.

2. Gleichstrom-Kurzkupplung nach Anspruch 1, dadurch gekennzeichnet, dass die vier Stromrichtertürme (24, 25, 26, 27) einen reckteckigen Grundriss bilden und derart angeordnet sind, dass die den Sekundärwicklungen der Stromrichtertransformatoren (28, 29) eines Netzes zugeordneten Stromrichtertürme (24, 25) und die den Sekundärwicklungen der Stromrichtertransformatoren (30, 31) des anderen Netzes zugeordneten Stromrichtertürme (26, 27) parallel zu den Stromrichtertransformatoren nebeneinanderliegen und die den in Dreieck geschalteten Sekundärwicklungen beider Netze zugeordneten Stromrichtertürme (25, 27) und die den in Stern geschalteten Sekundärwicklungen beider Netze zugeordneten Stromrichtertürme (24, 26) einander gegenüberliegen.

3. Gleichstrom-Kurzkupplung nach Anspruch 1 oder 2, dadurch gekennzeichnet, dass die Stromrichtertürme (24, 25, 26, 27), die Stromrichtertransformatoren (28, 29, 30, 31) sowie die Steuerungselektronik (39, 40) für die Thyristoren (20) auf gleicher baulicher Ebene stehen.

## Claims

1. Spatial arrangement of converter functional groups of a direct current tight coupling for the electrical interconnection of two asynchronous high-voltage three-phase current networks (1, 2) consisting of a three-phase current full wave-converter arrangement associated with each of the networks to be coupled, with converter transformers (6, 7, 9, 10) and controllable semiconductors which are so controlled by a central control electronics unit that the converter arrangement on the input side works as a rectifier and the converter arrangement on the output side works as a d.c.-a.c. inverter, and the controllable semiconductors of individual functional groups are superimposed in such a way that similarly constructed converter towers are formed which are connected to one another on the d.c. current side with equal poles, and on the three phase current side are connected to the associated secondary windings of the converter transformers connected in star arrangement and in delta, characterised in that each of the full-wave semiconductor sub-assemblies associated with the four secondary windings of the converter transformers (28, 29, 30, 31) form a converter tower (24, 25, 26, 27).

2. Direct current tight coupling according to claim 1, characterised in that the four converter towers (24, 25, 26, 27) form a rectangular outline and are so arranged that the converter towers (24, 25) associated with the secondary windings of the converter transformers (28, 29) of a network, and the converter towers (26, 27) associated with the secondary windings of the converter transformers (30, 31) of the other network lie adjacent to one another parallel to the converter transformers, and the converter towers (25, 27) associated with the secondary windings of both networks connected in delta, and the converter towers (24, 26) associated with the secondary windings of both networks connected in star arrangement lie opposite one another.

3. Direct current tigh coupling according to claim 1 or 2, characterised in that the converter towers (24, 25, 26, 27), the converter transformers (28, 29, 30, 31) and the control electronics (39, 40) for the thyristors (20) stand on a similar structural plane.

## Revendications

1. Agencement spatial de groupes fonctionnels de convertisseurs de courant d'un couplage serré à courant continu pour l'interconnexions de deux réseaux triphasés asynchrones à haute tension (1, 2), constitué par un ensemble de convertisseurs de courant triphasés fonctionnant sur deux alternances, reliés à chacun des réseaux devant être accouplés et comportant des transformateurs (6, 7, 9, 10) reliés aux convertisseurs de courant, et des semiconducteurs commandables, qui sont commandés par un système électronique central de commande de telle sorte que l'ensemble, situé du côté entrée, de convertisseurs de courant travaille à la manière d'un redresseur et l'ensemble, situé du côté sortie, de convertisseurs de courant travaille à la manière d'un onduleur et les semiconducteurs commandables de différents groupes fonctionnels sont disposés les uns au-dessus des autres de manière à former des piles de convertisseurs de courant, de même constitution, qui sont reliés entre elles, du point de vue du courant continu, par des pôles dew même nom et sont reliées, du point de vue du courant triphasé, aux enroulement secondaires associés, branchés en étoile et en triangle, des transformateurs reliés aux convertisseurs de courant, caractérisé par le fait que chacun des modules à semiconducteurs fonctionnant sur deux alternances, qui sont associés aux quatre enroulements secondaires des transformateurs (28, 29, 30, 31) reliés aux convertisseurs de courant, forme une pile (24, 25, 26, 27) de convertisseurs de courant.

2. Accouplement serré à courant continu suivant la revendication 1, caractérisé par le fait que les quatre piles (24, 25, 26, 27) de convertisseurs de courant délimitent un contour rectangulaire en projection horizontale et sont disposées de telle sorte que les piles (24, 25) de convertisseurs de courant, associées aux enroulements secondaires des transformateurs (28, 29), reliés aux convertisseurs de courant, d'un réseau, et les piles (26, 27) de convertisseurs de courant, associées aux enroulements secondaires des transformateurs (30, 31), reliés aux convertisseurs de courant, de l'autre réseau sont disposées côté-à-côté en parallèle avec les transformateurs reliés aux convertisseurs de courant et que les piles (25, 27) de convertisseurs de courant, associées aux enroulements secondaires, branchés an triangle, des deux réseaux et les piles (24, 26) de convertisseurs de courant, associées aux enroulements secondaires, branchés en étoile, des deux réseaux sont disposées réciproquement en vis-à-vis.

3. Couplage serré à courant continu suivant la revendication 1 ou 2, caractérisé par le fait que les piles (24, 25, 26, 27) de convertisseurs de courant, les transformateurs (28, 29, 30, 31) reliés aux convertisseurs de courant ainsi que le système électronique de commande (39, 40) pour les thyristors (20) sont disposés dans un même plan de montage.

0 151 271

FIG 1

FIG 2

7

**FIG 3**

**FIG 4**

**FIG 5**